**Europäisches Patentamt**

**European Patent Office**

**Office européen des brevets**

(19)

(11) Veröffentlichungsnummer: **0 008 389**
**B1**

# (12) EUROPÄISCHE PATENTSCHRIFT

(45) Veröffentlichungstag der Patentschrift:
**21.09.83**

(21) Anmeldenummer: **79102717.0**

(22) Anmeldetag: **31.07.79**

(51) Int. Cl.³: **G 03 F 7/02** // H01L21/31

(54) **Verfahren zur Stabilisierung einer Bildschicht auf einer Unterlage.**

(30) Priorität: **24.08.78 US 936425**

(43) Veröffentlichungstag der Anmeldung:
**05.03.80 Patentblatt 80/5**

(45) Bekanntmachung des Hinweises auf die Patenterteilung:
**21.09.83 Patentblatt 83/38**

(84) Benannte Vertragsstaaten:
**DE FR GB**

(56) Entgegenhaltungen:
**DE-A-2 703 738**
**DE-A-2 726 813**
**US-A-3 806 365**
**US-A-3 880 684**

(73) Patentinhaber: **International Business Machines Corporation, Old Orchard Road, Armonk, N.Y. 10504 (US)**

(72) Erfinder: **Ma, William Hsioh-Lien, 3 Cameron Lane, Wappingers Falls, N.Y. (US)**

(74) Vertreter: **Kreidler, Eva-Maria, Dr. rer. nat. et al, Schönaicher Strasse 220, D-7030 Böblingen (DE)**

Verfahren zur Stabilisierung einer Bildschicht auf einer Unterlage

Die Erfindung betrifft ein Verfahren zur Stabilisierung einer Bildschicht aus einem organischen polymeren Resistmaterial auf einer Unterlage, bei dem diese mit der Bildschicht einer Glimmentladung in einer fluorhaltigen Atmosphäre unterworfen wird.

Viele Verfahren zur Erzeugung von Mikrobildern, beispielsweise bei der Herstellung integrierter Schaltkreise, erfordern hohe Temperaturen. Die obere Grenze der Behandlungstemperatur wird jedoch oft durch die Materialeigenschaften der verwendeten Resistmasken begrenzt. Die Deformation des Resistbilds während des Hochtemperaturhärtens, insbesondere bei Temperaturen grösser als 200°C, hat auch einen Einfluss auf die untere Grenze der Bildgrösse des Resistmaskenmusters und daher auf die Produktgeometrie. Organische Polymerresist-Bildschichten werden in üblicher Weise nach der Entwicklung gehärtet, um die Resisthaftung und die physikalischen Eigenschaften des Resists zu verbessern. Eine Härtung ist notwendig, um dem Resist Widerstandsfähigkeit gegenüber den Chemikalien, die zur Ätzung der Unterlage verwendet werden und/oder gegenüber einer Hochtemperaturbehandlung, die bei der Metallabscheidung ohne Abtrennung des Resists von der Unterlage angewendet wird, zu verleihen, oder um ein Fliessen des Bildes zu vermeiden. Das Bildfliessen ist in der integrierten Schaltkreistechnologie von besonderer Bedeutung bei der Erzeugung von Mikrobildern, deren Dimensionen mit dem Fortschreiten der Technik immer kleiner werden und wenn immer feinere Linien gefordert werden. Die Resistschicht wird wenigstens bei einer Temperatur gehärtet, auf die sie erwartungsgemäss während der Behandlung der Unterlagen erhitzt wird. Der Härtprozess seinerseits ist auf die Zeiten und Temperaturen beschränkt, bei denen die Bildverformung aufgrund des Fliessens so klein wie möglich ist. Wenn die zulässigen Härtungsbedingungen unzureichend sind, um die erforderlichen Resisteigenschaften zu erhalten, muss eine andere Technik zur Verbesserung der Resistbeständigkeit angewendet werden.

Bisherige Techniken zur Verbesserung der Resistbildbeständigkeit schliessen eine Behandlung des Resistbildes, bei der die bildtragende Unterlage einer Glimmentladung auf einer Elektrode in inerter Gasatmosphäre wie Argon, Stickstoff oder Mischungen von Stickstoff und Wasserstoff ausgesetzt wird, ein. Ein Verfahren dieser Art ist in der «Defensive Publication» T883005 des Amerikanischen Patentamtes vom 2. Februar 1971 veröffentlicht. Eine Behandlung von Resistbildern in einer Glimmentladung mit Sauerstoff wird beispielsweise in den US-Patentschriften 3816196 und 3920483 beschrieben. Wenn, wie in T883005 beschrieben, die das Resistbild tragenden Unterlagen in einem Plasma auf einer Elektrode angeordnet und einer Ionenbeschiessung ausgesetzt werden, kann eine Beständigkeit der Resistschichten gegenüber hohen Temperaturen durch Wahl der geeigneten Bedingungen erreicht werden. Es wurde jedoch gefunden, das bei einer elektrodenlosen Plasmabehandlung mit Sauerstoff oder einem inerten Gas die Resistbildbeständigkeit bis zu Temperaturen von nur etwa 210°C gewährleistet werden kann. Wenn eine Beständigkeit bei Temperaturen über diesen Wert hinaus erhalten werden soll und es unerwünscht oder unpassend ist, eine Ionenbeschiessung der Resistschicht und der Unterlage vorzunehmen, ist eine verbesserte elektrodenlose Plasmabehandlung erforderlich.

Aus der deutschen Offenlegungsschrift 2703738 ist ein Verfahren zur Verbesserung der Hafteigenschaften von Photolack bekannt, bei dem eine Halbleiteranordnung in ein Tetrafluormethanplasma eingebracht wird, dessen Druck vorzugsweise zwischen 0,6666 und 1,3332 mbar liegt. Die Behandlungszeit beträgt etwa 1 bis 3 Minuten, und bei der Behandlung herrschen relativ niedere Temperaturen von etwa 40°C. Durch diese Behandlung der Halbleiteranordnung kann die Haftfestigkeit des Photolacks auf der Unterlage verbessert werden.

Erfindungsgemäss wurde festgestellt, dass durch eine Glimmentladung allein eine Resistbeständigkeit gegen Fliessen während nachfolgender Temperaturprozesse bei Temperaturen > 300°C nicht zu erzielen ist. Auch kann das Profil der Resistbildseitenwände mit dem in der Offenlegungsschrift angegebenen Verfahren nicht beeinflusst werden.

Aufgabe der Erfindung ist ein Verfahren zur Stabilisierung einer Bildschicht aus einem polymeren Resistmaterial auf einer Unterlage, welches durch die Stabilisierung ein Erhitzen oder Härten der Resistschichten auf Temperaturen bis mindestens etwa 330°C möglich macht und wodurch eine hohe Resistbildbeständigkeit bei nachfolgenden Hochtemperaturprozessen erhalten wird.

Die Aufgabe der Erfindung wird gelöst durch ein Verfahren, das dadurch gekennzeichnet ist, dass die Glimmentladung elektrodenlos ist und dass die Unterlage mit der Bildschicht im Anschluss an die elektrodenlose Glimmentladung auf mindestens 210°C erhitzt wird.

In einer vorteilhaften Ausgestaltung der Erfindung wird die Bildschicht einer elektrodenlosen Glimmentladung unterworfen und anschliessend auf 210 bis 330°C erhitzt. Weitere vorteilhafte Ausgestaltungen der Erfindung sind in den Unteransprüchen niedergelegt.

Mit dem erfindungsgemässen Stabilisierungsverfahren können Resistbilder erhalten werden, die bei einer Behandlung bei Temperaturen von über 300°C nicht fliessen.

Die Erfindung wird anhand der nachfolgenden speziellen Beschreibung und der Ausführungsbeispiele näher erläutert. Das erfindungsgemässe Verfahren dient zur Stabilisierung von Bildschichten aus einem organischen Polymermaterial auf einer Unterlage. Die das Resistbild tragende Unterlage wird einer elektrodenlosen Glimmentladung bei niedrigem Druck in einer fluorhaltigen Atmosphäre unterworfen, um die freiliegende Oberfläche der Schicht zu härten, und anschliessend wird die Schicht erhitzt.

Reaktoren zur elektrodenlosen Glimmentladung, die für das erfindungsgemässe Verfahren geeignet sind, sind im Handel erhältlich. Beispiele hierfür sind induktiv wirkende Hochfrequenz-Entladungsreaktoren oder kapazitiv wirkende Reaktoren. Die Reaktoren enthalten eine Elektrode oder Elektroden, die mit einer Hochfrequenz-Spannungsquelle verbunden sind. Zwischen den Elektroden befindet sich eine Kammer aus Glas, in die die zu behandelnde Probe gebracht wird. Die Kammer hat einen Auslass, der mit einer Vakuumpumpe zur Erzeugung eines erniedrigten Druckes in der Kammer verbunden ist und einen Gaseinlass zur Einführung der gewünschten Atmosphäre in die Kammer und Mittel zur Kontrolle des Gasflusses.

Die Druck- und Leistungsparameter, die für das erfindungsgemässe Verfahren geeignet sind, sind im allgemeinen so zu wählen, dass eine stabile Glimmentladung erhalten wird, mit der eine ausreichende Resisthärtung ohne Verlust an Resist möglich ist. Geeignete Drucke liegen in einem Bereich von etwa 0,13332 mbar bis 1,9998 mbar, und die Leistung reicht von etwa 25 bis 500 Watt.

Die Behandlungszeiten für brauchbare Ergebnisse können sehr kurz sein und liegen im allgemeinen zwischen etwa 15 Sekunden bis 15 Minuten. Bevorzugte Zeiten liegen zwischen etwa 15 Sekunden und 3 Minuten, wobei die kürzeste Zeit eine noch brauchbare Härtung ergibt. Zeiten länger als einige Minuten können auch angewendet werden, sind aber nicht notwendig. Überraschenderweise wurde gefunden, dass das Profil der Resistbildseitenwände durch Variation der Behandlungszeiten verändert werden kann, ohne dass die Dimensionen des Resistbildes, welches sich mit der Unterlage in Kontakt befindet, verändert werden. Mit kurzen Zeiten für die Glimmentladung von 15 bis 30 Sekunden werden gerade Seitenwände nach der Resisthärtung erhalten. Ein derartiges Bild ist erwünscht, um die niedrigstmögliche Unterätzung zu erhalten oder eine Metall-lift-off-Lippe oder ein überhängendes Profil zu gewährleisten. Bei längeren Behandlungszeiten von etwa 2 Minuten wird ein abgerundetes Resistbildprofil erhalten, welches den Erhalt einer Resistbildschicht gestattet, die wegen der genauen Wiedergabe des Resistbildprofils beim Plasmaätzen der Unterlage die Herstellung von sich verjüngenden Seitenwänden in den Unterlagen ermöglicht. Ein derartiges Profil ist beispielsweise erwünscht, wenn während der Herstellung integrierter Schaltkreise Durchführungsöffnungen in Quartz geätzt werden und scharfe Quartzkanten an der Oberfläche vermieden werden sollen und eine gute metallische Haftung erwünscht ist. Die Gründe für die Abrundung sind nicht vollständig bekannt, aber es wird angenommen, dass durch die längeren Behandlungszeiten eine dickere Haut auf dem Resistbild erhalten wird, welche Lösungsmittelreste in der Resistschicht zurückhält und eine Abrundung beim Erhitzen bewirkt. Dieses Lösungsmittel entweicht durch die Haut, die bei den kürzeren Behandlungszeiten gebildet wird.

Geeignete Verbindungen in der Atmosphäre der Kammer für die Bildhärtung müssen fluorhaltig sein. Bevorzugte organische fluorhaltige Verbindungen weisen 1 bis 3 Kohlenstoffatome auf. Beispiele für geeignete Verbindungen sind: $CF_4$ $C_2F_6$, $C_3F_8$, $CBrF_3$, $CCl_2F_2$, $CHClF_2$ und $CHF_3$.

Auch $SF_6$ und Mischungen der zuvor angegebenen Verbindungen können angewendet werden. Andere Gase wie Edelgase, Stickstoff oder reaktive Gase wie Luft oder Sauerstoff können auch vorhanden sein, sind aber für die Durchführung des erfindungsgemässen Verfahrens nicht erforderlich.

Mit dem erfindungsgemässen Verfahren können entweder positiv- oder negativ-arbeitende Resistmaterialien gehärtet werden. Materialien dieser Art sind strahlungs-, d.h. Licht-, Elektronenstrahl- oder Röntgenstrahl empfindliche organische Polymermaterialien, welche bei entsprechender Belichtung und Entwicklung ein Bildmuster erzeugen. Resistfilme, die bei Bestrahlung unlöslich werden, werden als negativ-arbeitende Resistmaterialien bezeichnet. Der nicht belichtete Film wird entwickelt (durch einen Entwickler gelöst) unter Zurücklassung nicht bedeckter Bereiche der Substratoberfläche. Demgegenüber werden Resistfilme, die bei Bestrahlung löslich werden, als positiv-arbeitende Resistmaterialien bezeichnet. Typische Beispiele positiv-arbeitender Resistmaterialien sind mit Diazoketonen aktivierte Phenol-Formaldehyd-Novolakharze, die beispielsweise von der Firma Shipley unter den Handelsbezeichnungen AZ 1350 und AZ 111 vertrieben werden. Beispiele negativ-arbeitender Resistmaterialien sind mit Aziden sensibilisierte cyclisierte cis-Isopren-Polymere, die von der Firma Kodak unter der Bezeichnung KTFR-Resistmaterialien vertrieben werden.

Beispiel 1

Ein aus einer Schicht bestehendes Resistbild für das Metall-lift-off-Verfahren wurde auf einer oxidierten Oberfläche eines Siliciumhalbleiterwafers hergestellt. Eine etwa 2000 nm dicke Resistschicht aus m-Kresol-Formaldehyd-Novolakharz und einen Diazoketonsensibilisator, welcher als 2-Diazo-1-oxo-naphthalin-5-sulfonsäureester des 2,3,4-Trihydroxybenzophenons identifiziert wurde, in einem Verhältnis von etwa 75 Gew.-% Polymer und 25 Gew.-% Sensibilisator wurde durch Verspinnen einer Lösung auf den Wafer aufgetragen und dann in dem gewünschten Bildmuster mit ultraviolettem Licht bestrahlt. Man liess die bestrahlten Bereiche einige Minuten in Chlorbenzol quellen, und anschliessend wurde in einem schwach alkalischen Entwickler entwickelt, um die bestrahlten Bereiche der Schichten zu entfernen. Die Behandlung mit Chlorbenzol bewirkt eine überstehende Lippe an der Oberfläche der Resistschicht, deren Funktion es ist, eine Unterbrechung zwischen den Teilen des Metallfilms, welche auf der Unterlage abgeschieden werden und den Teilen des Metallfilms, welche auf der Oberfläche der Resistschicht abgeschieden werden, hervorzurufen. Dadurch wird ermöglicht, dass die zuletzt genannten Teile zusammen mit dem Resist abgehoben werden können unter Erhalt des gewünschten Metallisierungsmusters auf der Unterlage. Die Lippe muss während der nachfolgenden Resistnachhärtungs-Prozesse oder der Heissprozesse zur Metallabscheidung erhalten bleiben. Die entwickelten Proben wurden dann in einen Plasmareaktor gegeben und 30 Sekunden lang einer Glimmentladung bei einem Druck von etwa 0,6666 mbar und einer Leistung von 25 Watt in einer Atmosphäre von $CF_4$ oder $CF_4$ mit einem Gehalt an etwa 8 Volumprozent Sauerstoff unterworfen. Nach dieser Behandlung wurden die Proben auf eine Heizplatte gegeben und 20 Minuten lang in Stickstoffatmosphäre bei 330°C gehärtet. Eine Prüfung des Resistbildquerschnitts mittels Elektronenmikroskop im Anschluss an die Härtung ergab, dass der Resistüberhang sogar nach der Härtung bei hohen Temperaturen erhalten blieb. Andere Proben mit der zuvor beschriebenen lift-off-Struktur wurden in einem Plasma mit Sauerstoff, Stickstoff und Argon unter den gleichen Bedingungen und anderen Bedingungen hinsichtlich Zeit, Druck und Leistung behandelt, um so optimale Ergebnisse zu erhalten, aber in allen diesen Fällen konnte ein Fliessen des Resistbildes und ein Verlust des Überhangs oder der Lippe während der Härtung bei Temperaturen grösser 210°C nicht vermieden werden.

Beispiel 2

Bei Ionenimplantationsverfahren, bei denen durch eine Resistmaske aktive Bereiche in der Oberfläche eines Siliciumhalbleitermaterials erzeugt werden, ist ein vertikales Resistbildprofil erforderlich. Ein Abrunden des Resistprofils durch Erhitzen und Fliessen des Resists während der Ionenimplantation würde bewirken, dass der Resist an den Kanten der Bilder, die in Kontakt mit der Unterlage sind, dünn wird. Daraus würde ein laterales, ionenimplantiertes, dotiertes Profil resultieren, weil die Ionen durch die dünnen Resistteile eindringen. Wenn nahe beieinanderliegende aktive Bereiche in hochintegrierten Strukturen gebildet werden sollen, kann dieses laterale Dotieren bewirken, dass ein Bereich einen anderen überlappt und dadurch die Vorrichtung zerstört. Es wurde auch beobachtet, dass das Entweichen von Lösungsmittelrückständen oder anderen Materialien aus einer nicht behandelten Resistschicht während der Ionenimplantation Blasen in dem zu bildenden Resist erzeugen kann. Wenn diese Blasen um einen aktiven Bereich der Vorrichtung gebildet werden, kann die Vorrichtung während der Ionenimplantation zerstört werden. Proben von Siliciumhalbleiterwafern wurden mit einer 1 µm dicken Schicht eines positivarbeitenden Resists, der beispielsweise von der Firma Shipley unter der Handelsbezeichnung AZ 1350 J erhältlich ist und die Zusammensetzung, die in Beispiel 1 angegeben ist, hat, beschichtet, belichtet und entwickelt unter Ausbildung eines Musters für die Ionenimplantation von Arsen in die Oberfläche des Silicimhalbleiterwafers. Die entwickelten, den Resist tragenden Unterlagen wurden dann in einen Plasmareaktor gegeben und bei einem Druck von etwa 0,6666 mbar mit 25 Watt Leistung 15 bis 30 Sekunden lang in einer Atmosphäre von $CF_4$ mit einem Gehalt an etwa 8 Volumprozent Sauerstoff behandelt. Verschiedene Proben wurden dann auf einer Heizplatte entweder 20 Minuten lang bei 330° oder 30 Minuten lang bei 300° in einer Stickstoffatmosphäre gehärtet und dann einer Arsenionenimplantation bei 50 keV und einer Energie von 4 mA unterworfen. Eine Untersuchung mit dem Elektronenmikroskop vor und nach der Ionenimplantationsbehandlung ergab keinen Abbau des Resistprofils, und der Resist konnte von der Unterlage ohne erkennbaren Rückstand entfernt werden. Im Gegensatz hierzu waren Proben, welche keiner Plasmahärtung oder einer Sauerstoffplasmabehandlung unterworfen wurden, bei Temperaturen über 210°C nicht stabil, und die nicht behandelten Proben zeigten eine Blasenbildung in der Resistschicht.

Beispiel 3

Siliciumwaferproben mit einer oxidierten Oberfläche wurden mit einer 2 µm dicken Schicht eines positiv-arbeitenden Resists, der aus einem Phenolformaldehyd-Novolak-Harz, sensibilisiert mit einem 2-Diazo-1-oxo-naphthalin-5-sulfonsäureester des 2,4-Dihydroxybenzophenons, bestand, beschichtet und ultravioletter Strahlung ausgesetzt unter Ausbildung eines Musters, welches mit einem schwach alkalischen Entwickler entwickelt wurde. Die entwickelten Proben wurden dann in einen Ätzer gegeben und 2 Minuten lang in einer Atmosphäre von $CF_4$ und 8 Volumprozent Sauerstoff bei einer Leistung von 25 Watt und einem Druck von 0,6666 mbar behandelt und anschliessend 30 Minuten lang in einer Stickstoffatmosphäre bei 210°C gehärtet. Nach dem Härten waren die Dimensionen der Resistöffnungen nicht verändert, aber Elektronenmikroskopaufnahmen zeigten, dass anstelle der rechteckigen Querschnitte ein nahezu halbkreisförmiger Querschnitt erhalten wurde. Mit dem Härtungsschritt wurde automatisch ein gewünschtes Resistprofil nach Mass erhalten, das bei hohen Temperaturen (über 300°C) beständig war. Beim Ätzen des Oxids mit einem Plasma wurde das Resistprofil in der Oxidschicht abgebildet unter Erhalt von Öffnungen in der Oxidschicht mit eher runden als scharfen Kanten an der Oberseite, so dass auf das Oxid leicht und ohne Unterbrechungen eine Metallschicht aufgedampft werden konnte.

Beispiel 4

Mit Resist bedeckte Wafer wurden belichtet und entwickelt wie in Beispiel 3 angegeben. Die entwickelten Proben wurden in Plasmen bei einem Druck von 0,6666 mbar und einer Leistung von 50 Watt 30 Sekunden lang in einer Atmosphäre von $CBrF_3$, $C_2F_6$, $CCl_2F_2$ oder $CHClF_2$ behandelt. Die Proben wurden dann 20 Minuten lang bei 210°C behandelt. In jedem Fall blieb das Resistbild durch die angewendete Plasmahärtung erhalten.

In den zuvor beschriebenen Beispielen wurde ein Verfahren zur Härtung von Resistbildern beschrieben, das durch die Anwendung einer elektrodenlosen Glimmentladung Temperaturbeständigkeiten der Resistbilder bis zu sehr hohen Temperaturen von über 300°C gestattet.

## Patentansprüche

1. Verfahren zur Stabilisierung einer Bildschicht aus einem organischen polymeren Resistmaterial auf einer Unterlage, bei dem diese mit der Bildschicht einer Glimmentladung in einer fluorhaltigen Atmosphäre unterworfen wird, dadurch gekennzeichnet, dass die glimmentladung elektrodenlos ist und dass die Unterlage mit der Bildschicht im Anschluss an die elektrodenlose Glimmentladung auf mindestens 210°C erhitzt wird.

2. Verfahren nach Anspruch 1, dadurch gekennzeichnet, dass die Unterlage mit der Bildschicht auf 210 bis 330°C erhitzt wird.

3. Verfahren nach Anspruch 1, dadurch gekennzeichnet, dass die fluorhaltige Atmosphäre aus einer fluorsubstituierten organischen Verbindung mit 1 bis 3 Kohlenstoffatomen, SF$_6$ oder Mischungen derselben gebildet wird.

4. Verfahren nach den Ansprüchen 1 und 3, dadurch gekennzeichnet, dass die Unterlage mit der Bildschicht 15 Sekunden bis 15 Minuten lang der Glimmentladung unterworfen wird.

5. Verfahren nach Anspruch 4, dadurch gekennzeichnet, dass die Unterlage mit der Bildschicht 15 bis 30 Sekunden lang der Glimmentladung unterworfen wird.

6. Verfahren nach Anspruch 4, dadurch gekennzeichnet, dass zur Erzeugung eines abgerundeten Resistprofils die Unterlage mit der Bildschicht wenigstens 2 Minuten lang der Glimmentladung unterworfen wird.

7. Verfahren nach einem oder mehreren der Ansprüche 1 bis 6, dadurch gekennzeichnet, dass für die Glimmentladung Drucke von 0,13332 mbar bis 1,9998 mbar und eine Leistung von 25 bis 500 Watt angewendet werden.

8. Verfahren nach einem oder mehreren der Ansprüche 1 bis 7, dadurch gekennzeichnet, dass eine fluorhaltige Atmosphäre mit einem Gehalt an CF$_4$, ein Druck von etwa 0,6666 mbar, eine Leistung von etwa 25 Watt und Behandlungszeiten von etwa 15 Sekunden bis 2 Minuten angewendet werden.

## Claims

1. Method of stabilizing an image layer consisting of an organic polymeric resist material on a substrate, where it is exposed with the image layer to a glow discharge in a fluorine-containing atmosphere, characterized in that the glow discharge is electrodeless, and that subsequent to the electrodeless glow discharge the image layer-bearing substrate is heated to at least 210°C.

2. Method as claimed in claim 1, characterized in that the image layer-bearing substrate is heated to 210 to 330°C.

3. Method as claimed in claim 1, characterized in that the fluorine-containing atmosphere is generated of a fluorine-substituted organic compound with 1 to 3 carbon atoms, SF$_6$ or mixtures thereof.

4. Method as claimed in claim 1 and 3, characterized in that the image layer-bearing substrate is subjected to the glow discharge for 15 seconds to 15 minutes.

5. Method as claimed in claim 4, characterized in that the image layer-bearing substrate is subjected to the glow discharge for 15 to 30 seconds.

6. Method as claimed in claim 4, characterized in that for generating a rounded resist profile the image layer-bearing substrate is subjected to the glow discharge for at least 2 minutes.

7. Method as claimed in any one or several of claims 1 to 6, characterized in that for the glow discharge pressures of 0.13332 mbar to 1.9998 mbar and a power ranging from 25 to 50 Watt are applied.

8. Method as claimed in any one or several of claims 1 to 7, characterized in that a fluorine-containing atmosphere containing CF$_4$, a pressure of approximately 0.6666 mbar, a power of approximately 25 Watt, and processing times of approximately 15 seconds to 2 minutes are used.

## Revendications

1. Procédé de stabilisation d'une couche image composée d'un matériau organique de type résist obtenue par polymérisation sur un support, où l'on expose ledit support portant ladite couche image à une décharge luminescente dans une atmosphère contenant du fluor, caractérisé en ce que ladite décharge luminescente est effectuée sans électrode, et en ce que ledit support portant ladite couche image est chauffé à une température minimale de 210°C immédiatement après la décharge luminescente.

2. Procédé selon la revendication 1, caractérisé en ce que le support portant ladite couche image est chauffé à une température comprise entre 210 et 330°C.

3. Procédé selon la revendication 1, caractérisé en ce que ladite atmosphère de fluor est une composition organique se substituant au fluor, contenant de 1 à 3 atomes, de carbone, de SF$_6$, ou autres mélanges du même genre.

4. Procédé selon les revendications 1 et 3, caractérisé en ce que le support portant la couche image est exposé à ladite décharge luminescente pendant une période allant de 15 secondes à 15 minutes.

5. Procédé selon la revendication 4, caractérisé en ce que le support portant la couche image est exposé à ladite décharge luminescente pendant une période allant de 15 à 30 secondes.

6. Procédé selon la revendication 4, caractérisé en ce que, pour obtenir un motif arrondi du matériau résist, le support portant la couche image est exposé à ladite décharge luminescente pendant une période d'au moins deux minutes.

7. Procédé selon une ou plusieurs des revendications 1 à 6, caractérisé en ce qu'on utilise pour effectuer ladite décharge luminescente des pressions variant entre 0,13332 mbar et 1,9998 mbar et une puissance variant entre 25 et 50 watts.

8. Procédé selon l'une ou plusieurs des revendications 1 à 7, caractérisé en ce qu'il emploie une atmosphère au fluor contenant du $CF_4$, à une pression d'environ 0,6666 mbar, à une puissance d'environ 25 watts et qu'il nécessite des temps de traitement allant d'environ 15 secondes à 2 minutes.